(19) Europäisches Patentamt / European Patent Office / Office européen des brevets

(11) **EP 2 083 278 B1**

(12) **EUROPEAN PATENT SPECIFICATION**

(45) Date of publication and mention
of the grant of the patent:
**07.11.2018 Bulletin 2018/45**

(51) Int Cl.:
**G01R 31/08** *(2006.01)*     *G01R 35/00* *(2006.01)*
**H02H 3/38** *(2006.01)*

(21) Application number: **08150656.0**

(22) Date of filing: **25.01.2008**

(54) **Method and apparatus for determining location of phase-to-phase fault**

Verfahren und Vorrichtung zur Bestimmung der Position eines Phase-zu-Phase-Fehlers

Procédé et appareil de détermination de la localisation d'un défaut de phase à phase

(84) Designated Contracting States:
**DE FR GB IT**

(43) Date of publication of application:
**29.07.2009 Bulletin 2009/31**

(73) Proprietor: **ABB Schweiz AG**
**5400 Baden (CH)**

(72) Inventors:
- **Wahlroos, Ari**
**65350 Vaasa (FI)**
- **Altonen, Janne**
**37800 Toijala (FI)**

(74) Representative: **Kolster Oy Ab**
**(Salmisaarenaukio 1)**
**P.O. Box 204**
**00181 Helsinki (FI)**

(56) References cited:
**EP-A- 1 172 660**

- **IGEL M ET AL: "Distance protection of asymmetrical overhead lines" ELECTRICITY DISTRIBUTION. PART 1: CONTRIBUTIONS. CIRED. 14TH INTERNATI ONAL CONFERENCE AND EXHIBITION ON (IEE CONF. PUBL. NO. 438), LONDON, UK,IEE, UK, vol. 4, 2 June 1997 (1997-06-02), pages 21/1-21/7, XP006506461 ISBN: 978-0-85296-674-7**
- **ZANETTA JR L C ET AL: "Optimization Algorithm for Fault Location in Transmission Lines Considering Current Transformers Saturation" IEEE TRANSACTIONS ON POWER DELIVERY, IEEE SERVICE CENTER, NEW YORK, NY, US, vol. 20, no. 2, 1 April 2005 (2005-04-01), pages 603-608, XP011129361 ISSN: 0885-8977**
- **KAWADY T ET AL: "A practical fault location approach for double circuit transmission lines using single end data" IEEE TRANSACTIONS ON POWER DELIVERY, IEEE SERVICE CENTER, NEW YORK, NY, US, vol. 18, no. 4, 1 October 2003 (2003-10-01), pages 1166-1173, XP011103329 ISSN: 0885-8977**

**Description**

FIELD OF THE INVENTION

The present invention relates to localization of phase-to-phase faults in electric networks.

BACKGROUND OF THE INVENTION

Impedance-based fault locator functionality is nowadays a standard feature in modern microprocessor-based protective relays in electric networks such as distribution networks.

Document EP 1172660 discloses an example of fault location utilizing impedances. Document "Distance protection of asymmetrical overhead lines"; Igel, M.; Schenger, P.; Simon, R.; CIRED. 14th International Conference and Exhibition on Electricity Distribution. Part 1: Contributions. (IEE Conf. Publ. No. 438) Volume 4, 2-5 June1997, Pages: 21/1 - 21/7 discloses an example of distance protection based on impedance of short-circuit loops. Document "Optimization algorithm for fault location in transmission lines considering current transformers saturation"; Pereira, C. Ed. M.; Zanetta, L.C., Jr., IEEE Transactions on Power Delivery, Volume 20, Issue 2, April 2005, Pages: 603 - 608 discloses fault location calculations using voltages and currents during transient conditions and pre fault values. Document "A practical fault location approach for double circuit transmission lines using single end data"; Kawady, T.; Stenzel, J., IEEE Transactions on Power Delivery, Volume 18, Issue 4, October 2003 Pages: 1166 - 1173 discloses fault location calculation based on an apparent impedance method.

The performance of such a functionality has proven to be satisfactory in locating short-circuit faults. However, as electric utilities demand more accurate fault location procedures, all error sources affecting fault distance estimation should be eliminated.

One potential error source is line asymmetry. In reality power systems are never perfectly balanced in terms of fine geometry. Conductors of overhead lines are typically assembled in towers in such a way that electromagnetically the system is not symmetrical i.e. the distances between the conductors and/or from the conductors to the ground are not equal. This means that e.g. phase reactances $X_{L1}$, $X_{L2}$ and $X_{L3}$ are not equal because the asymmetry of the conductors makes mutual impedances of the phases unequal. The mutual impedances between the phases exist because the phases are magnetically coupled; thus a current flowing in any of the three phase conductors will induce a voltage into the other conductors. In a similar manner phase-to-phase loop (L1-L2, L2-L3 and L3-L1) reactances are unequal because of the asymmetry.

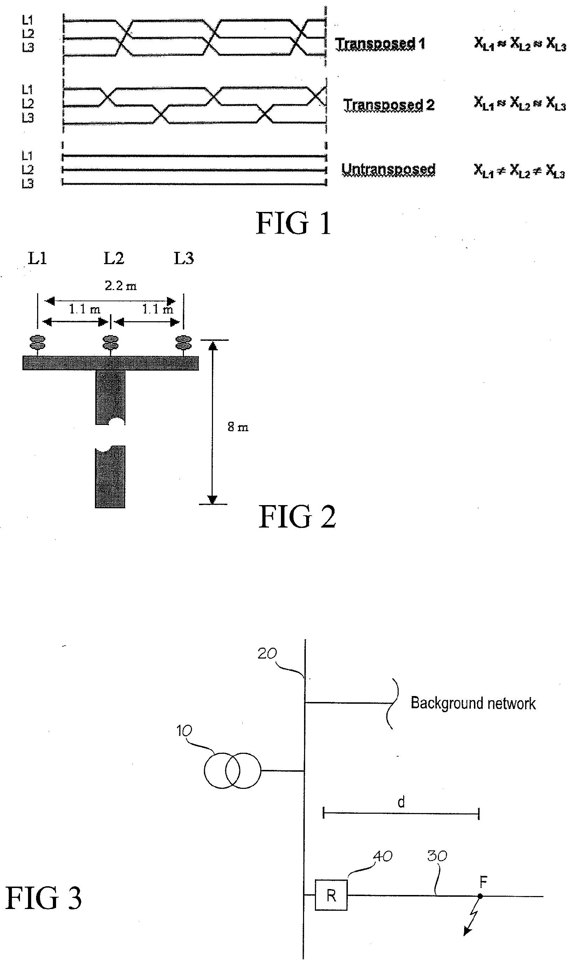

The above problem can be alleviated by transposing the phase conductors of the line as shown in Figure 1. However, in practice even a transposed line has at least some asymmetry between the phases L1, L2 and L3.

in fault location the asymmetry between the phases means that a two-phase fault at fault location d results in three different fault distance estimates, $d_{L12}$, $d_{L23}$ and $d_{L31}$, depending on the faulted phases. The effect of untransposed lines on impedance fault location algorithms can be illustrated with the following simple example.

Let us consider a 20 kV overhead line with Raven 54/6AlFe conductors. The line towers are 8 meters high (the conductors are 8 meters above the ground) and the phase configuration is "flat" with 1.1 meter phase distance as shown in Figure 2. The conductor radius is 0.00505 meter, DC-resistance 0.536 ohm/km and earth resistivity 2300 ohm-meter.

If the phase conductors of the exemplary line were ideally transposed, the positive sequence line reactance for all phases would be the same: $X_{1line}$ = 0.3691 ohm/km. In practice, however, the lines are not ideally transposed. This means that the distances between the phase conductors are not equal. When the line is assumed to be non-transposed, then every phase has an individual value of phase reactance:

$X_{L1}$ = 0.3786 ohm/km
$X_{L2}$ = 0.3434ohm/km
$X_{L3}$ = 0.3815ohm/km

Corresponding phase-to-phase loop reactances are then:

$X_{L12}$ = 0.3523 ohm/km
$X_{L23}$ = 0.3542 ohm/km
$X_{L31}$ = 0.3981 ohm/km

Compared with the ideally transposed value of $X_{1line}$ = 0.3691 ohm/km, the individual phase-to-phase loop reactance values would deviate as follows:

$X_{L12}$ = -0.0168ohm/km = -4.55 %

$X_{L23} = -0.0149\text{ohm/km} = -4.04\ \%$
$X_{L31} = 0.029\text{ohm/km} = 7.86\ \%$

This deviation in turn directly causes a corresponding error in the results of an impedance-based fault distance estimation. However, typically a total fault location error of only few percents would be tolerable in case of short-circuit fault location.

BRIEF DESCRIPTION OF THE INVENTION

An object of the present invention is to provide a method and an apparatus for implementing the method so as to overcome the above problem or at least to alleviate the problem. The objects of the invention are achieved by a method, a computer program product and an apparatus which are characterized by what is stated in the independent claims. The preferred embodiments of the invention are disclosed in the dependent claims.

The invention is based on the idea of determining, on the basis of values of current and voltage quantities monitored during one or more three-phase faults, phase-to-phase fault loop reactance unbalance correction factors, i.e. phase-to-phase fault loop specific correction factors which are relative to the amount of unbalance of the reactances of the phase-to-phase fault loops, and using such determined correction factors for compensating for the reactance unbalance between the phases when determining a distance to a point of phase-to-phase fault.

An advantage of the invention is that it allows the accuracy of phase-to-phase fault localization to be improved especially in untransposed power systems.

BRIEF DESCRIPTION OF THE DRAWINGS

In the following the invention will be described in greater detail by means of preferred embodiments with reference to the accompanying drawings, in which

Figure 1 is a diagram illustrating transposed and untransposed line configurations;
Figure 2 illustrates a line tower configuration;
Figure 3 is a diagram of an electric network in which the invention can be used;
Figure 4 is a diagram showing the value of a correction factor as a function of the fault distance according to an embodiment; and
Figure 5 is a diagram showing the value of the correction factor as a function of the fault distance according to an embodiment.

DETAILED DESCRIPTION OF THE INVENTION

The application of the invention is not limited to any specific system, but it can be used in connection with various three-phase electric systems to determine a location of a phase-to-phase fault on a three-phase electric line. The electric line can be a feeder, for example, and may be an overhead-line or a cable or a combination of both. The electric power system in which the invention is implemented can be an electric transmission or distribution network or a component thereof, for example, and may comprise several feeders or sections. Moreover, the use of the invention is not limited to systems employing 50 Hz or 60 Hz fundamental frequencies or to any specific voltage level.

Figure 3 is a simplified diagram illustrating an electric network in which the invention can be applied. The figure shows only the components necessary for understanding the invention. The exemplary network can be a medium voltage (e.g. 20 kV) distribution network fed through a substation comprising a transformer 10 and a busbar 20. The illustrated network also comprises electric line outlets, i.e. feeders, of which one 30 is shown separately. Other possible feeders as well as other network parts, except the line 30, are referred to as a 'background network'. The figure also shows a protective relay unit 40 at the beginning of line 30, and a point of earth fault F. The protective relay unit 40 may be located inside the substation. It should be noted that there may be any number of feeders or other network elements in the network. There may also be several feeding substations. Further, the invention can be utilized with a switching station without a transformer 10, for example. The network is a three-phase network although, for the sake of clarity, the phases are not shown in the figure. In the exemplary system of Figure 3, the functionality of the invention can be located in the relay unit 40. It is also possible that only some measurements are performed at the location of unit 40 and the results are then transmitted to another unit or units in another location for further processing. In other words, the relay unit 40 could be a mere measuring unit while the functionality of the invention, or part of it, could be located in another unit or units.

In the following, the three phases of the three-phase electricity system in which the invention is used are referred to as L1, L2, and L3. Monitored current and voltage values are preferably obtained by a suitable measuring arrangement including e.g. current and voltage transducers (not shown in the figures) connected to the phases of the electricity system.

In most of the existing protection systems, these values are readily available and thus the implementation of the invention does not necessarily require any separate measuring arrangements. How these values are obtained is of no relevance to the basic idea of the invention and depends on the particular electricity system to be monitored. A three-phase fault and a phase-to-phase fault on the three-phase electric line 30 and the corresponding faulted phase L1, L2, or L3 of the three-phase electric line of the electricity system to be monitored may be detected e.g. by a protective relay 40 associated with the electricity system. The particular way how such faults are detected and corresponding faulted phases are identified is of no relevance to the basic idea of the invention.

According to an embodiment, the phase-to-phase fault distance calculation comprises determining one or more sets of phase-to-phase fault loop reactance unbalance correction factors on the basis of values of current and voltage quantities monitored during one or more three-phase faults, respectively, each set of correction factors corresponding to a distance between the measuring point and a point of fault at which the respective three-phase fault occurs on the three-phase electric line. Thus, when a three-phase fault occurs, a set of phase-to-phase fault loop reactance unbalance correction factors corresponding to the distance between the measuring point and a point of fault at which the three-phase fault occurs on the three-phase electric line is determined. Such a set of phase-to-phase fault loop reactance unbalance correction factors is preferably determined each time when a three-phase fault occurs on the electric line. The set of phase-to-phase fault loop reactance unbalance correction factors preferably comprises a reactance unbalance correction factor for each of the three different phase-to-phase fault loops L12, L23 and L31.

According to an embodiment, the reactance unbalance correction factor for a phase-to-phase fault loop is a ratio of a three-phase fault loop reactance to the phase-to-phase fault loop reactance of the phase-to-phase fault loop in question. In accordance with this embodiment, the determination of a set of phase-to-phase fault loop reactance unbalance correction factors first comprises determining, when a three-phase fault occurs on the electric line 30, the distance d between the measuring point 40 and a point of fault F at which the three-phase fault occurs on the electric line 30 and the following fault loop reactances:

$X_{LoopL12}$ = reactance of phase-to-phase fault loop L12
$X_{LoopL23}$ = reactance of phase-to-phase fault loop L23
$X_{LoopL31}$ = reactance of phase-to-phase fault loop L31

and

$X_{LoopL123}$ = reactance of three-phase fault loop L123

The distance between the measuring point 40 and a point of fault F at which the three-phase fault occurs may be determined by any known method such as any impedance-based method. If the three-phase fault is an intentionally caused fault, then the distance is typically known without any calculations. The impedances, and thus the reactances, of the phase-to-phase loops may be determined e.g. as follows:

| Fault loop: | Fault loop equation: | Fault loop impedance |
|---|---|---|
| L12 | $\underline{U}_{L12}/\underline{I}_{L12} =$ | $\underline{Z}_1 + R_F/2$ |
| L23 | $\underline{U}_{L23}/\underline{I}_{L23} =$ | $\underline{Z}_1 + R_F/2$ |
| L31 | $\underline{U}_{L31}/\underline{I}_{L31} =$ | $\underline{Z}_1 + R_F/2$ |
| L123 | $\underline{U}_1/\underline{I}_1 =$ | $\underline{Z}_1 + R_F/2$ |

where

$\underline{U}_{L12}$ = Phase-to-phase voltage between phases L1 and L2 = $\underline{U}_{L1} - \underline{U}_{L2}$
$\underline{U}_{L23}$ = Phase-to-phase voltage between phases L2 and L3 = $\underline{U}_{L2} - \underline{U}_{L3}$
$\underline{U}_{L31}$ = Phase-to-phase voltage between phases L3 and L1 = $\underline{U}_{L3} - \underline{U}_{L1}$
$\underline{I}_{L12}$ = Current difference of phase currents L1 and L2 = $\underline{I}_{L1} - \underline{I}_{L2}$
$\underline{I}_{L23}$ = Current difference of phase currents L2 and L3 = $\underline{I}_{L2} - \underline{I}_{L3}$
$\underline{I}_{L31}$ = Current difference of phase currents L3 and L1 = $\underline{I}_{L3} - \underline{I}_{L1}$
$\underline{U}_{L1}$ = Phase-to-earth voltage of phase L1
$\underline{U}_{L2}$ = Phase-to-earth voltage of phase L2
$\underline{U}_{L3}$ = Phase-to-earth voltage of phase L3
$\underline{I}_{L1}$ = Phase current of phase L1
$\underline{I}_{L2}$ = Phase current of phase L2
$\underline{I}_{L3}$ = Phase current of phase L3

$\underline{U}_1$ = Positive sequence voltage = $\underline{U}_{L1} + \underline{a} \cdot \underline{U}_{L2} + \underline{a}^2 \cdot \underline{U}_{L3}$
$\underline{a}$ = phase shift operator = $\cos(120°) + j\sin(120°)$
$\overline{I1}$ = Positive sequence current
$\overline{R}_F$ = Fault resistance
$\underline{Z}_1 = R_1 + jX_1$ = Positive sequence impedance from the measuring point to the point of fault
$\overline{R}_1$ = Positive sequence resistance from the measuring point to the point of fault
$X_1$ = Positive sequence reactance from the measuring point to the point of fault

The reactance of the three-phase fault loop L123 can also be determined as $X_{LoopL123} = (X_{LoopL12} + X_{LoopL23} + X_{LoopL31})/3$.

After the fault loop reactances have been determined, the correction factors for the three different phase-to-phase fault loops can be determined as follows:

$$X_{LoopL12corr}(d) = X_{LoopL123}/ X_{LoopL12}$$

$$X_{LoopL23corr}(d) = X_{LoopL123}/ X_{LoopL23}$$

$$X_{LoopL31corr}(d) = X_{LoopL123}/ X_{LoopL31}$$

where
d is the fault distance

The correction factors are functions of the fault distance i.e. they depend on the fault distance as line configuration may change along the line e.g. when the line tower configuration changes. The above procedure for determining correction factors may be performed automatically in case of a three-phase fault on the electric line. The three-phase fault may be a real fault or an intentional "test fault" at known distance d from the measuring point.

The determined one or more sets of correction factors are preferably stored with their corresponding fault distances in a memory of the apparatus implementing the invention or in some other suitable storage means.

According to an embodiment, the phase-to-phase fault distance calculation further comprises determining, after a phase-to-phase fault occurs on the three-phase electric line, a phase-to-phase fault loop reactance and an initial estimate of a distance between the measuring point and the point of fault on the basis of current and voltage quantities monitored during the phase-to-phase fault. Thus, when a phase-to-phase fault occurs on the three-phase electric line 30, the corresponding phase-to-phase fault loop reactance $X_{LoopL12}$, $X_{LoopL23}$ or $X_{LoopL31}$ is determined as well as the initial estimate of distance d between the measuring point 30 and the point of fault F. The initial estimate of distance d may be determined by any known method. The initial estimate of distance d may be determined as follows:

$$d = X_{LoopLxy}/X_{1line}$$

where

$X_{LoopLxy}$ = The determined fault loop reactance $X_{LoopL12}$, $X_{LoopL23}$ or $X_{LoopL31}$
$X_{1line}$ = Positive sequence reactance of the electric line (ohm/km)

According to an embodiment, the phase-to-phase fault distance calculation further comprises determining a phase-to-phase fault loop reactance unbalance correction factor to be used on the basis of the determined one or more sets of phase-to-phase fault loop reactance unbalance correction factors and the initial estimate of the distance between the measuring point and the point of fault. Thus, when the initial estimate of the distance between the measuring point and the point of fault has been determined, a phase-to-phase fault loop reactance unbalance correction factor to be used may be determined on the basis of the determined one or more sets of phase-to-phase fault loop reactance unbalance correction factors and the initial estimate of the distance.

According to an embodiment, the determining of the phase-to-phase fault loop reactance unbalance correction factor to be used comprises first selecting, from among the determined one or more sets of phase-to-phase fault loop reactance unbalance correction factors, a set corresponding to a distance equal to the initial estimate of the distance between the measuring point and the point of fault, and selecting from the selected set a phase-to-phase fault loop reactance unbalance correction factor corresponding to the faulted phases of the phase-to-phase fault in question. In other words, the initial estimate of the distance between the measuring point and the point of fault is used to select a set of correction factors corresponding to the distance equal to the initial estimate and then a correct phase-to-phase fault loop reactance unbalance correction factor corresponding to the phase-to-phase fault in question is selected from the set.

According to an embodiment, when no determined set corresponds to the distance equal to the initial estimate, the determining of the phase-to-phase fault loop reactance unbalance correction factor to be used comprises selecting, from among the determined one or more sets of phase-to-phase fault loop reactance unbalance correction factors, a set corresponding to a distance closest to the initial estimate of the distance between the measuring point and the point of fault; and selecting from the selected set a phase-to-phase fault loop reactance unbalance correction factor corresponding to the faulted phases of the phase-to-phase fault in question. In other words, if no set of correction factors corresponds to the distance equal to the initial distance estimate, then it is possible to use a set of correction factors corresponding to a distance closest to the initial estimate instead.

According to an alternative embodiment, when no determined set corresponds to the distance equal to the initial estimate, the determining of the phase-to-phase fault loop reactance unbalance correction factor to be used comprises determining a phase-to-phase fault loop reactance unbalance correction factor corresponding to the distance equal to the initial estimate by means of interpolation on the basis of the determined one or more sets of phase-to-phase fault loop reactance unbalance correction factors. Thus, according to this embodiment, if no set of correction factors corresponds to the distance equal to the initial distance estimate, then it is possible to determine the required phase-to-phase fault loop reactance unbalance correction factor by interpolation from the determined one or more sets of phase-to-phase fault loop reactance unbalance correction factors.

According to an embodiment, the phase-to-phase fault distance calculation further comprises, after the phase-to-phase fault loop reactance unbalance correction factor to be used has been determined, correcting the determined phase-to-phase fault loop reactance with the determined phase-to-phase fault loop reactance unbalance correction factor to be used. The corrected phase-to-phase fault loop reactance values are calculated as folllows:

$$X_{LoopL12correct} = X_{LoopL12corr} * X_{LoopL12}$$

$$X_{LoopL23correct} = X_{LoopL23corr} * X_{LoopL23}$$

$$X_{LoopL31correct} = X_{LoopL31corr} * X_{LoopL31}$$

Finally, according to an embodiment, when the corrected phase-to-phase fault loop reactance $X_{LoopL12correct}$, $X_{LoopL23correct}$ or $X_{LoopL31correct}$ is obtained, a corrected estimate of distance d between the measuring point 40 and the point of fault F is determined on the basis of the corrected phase-to-phase fault loop reactance. The corrected estimate of distance d may be determined e.g. as follows:

$$d = X_{LoopLxycorrect}/X_{1line}$$

where

$X_{LoopLxycorrect}$ = The corrected fault loop reactance $X_{LoopL12correct}$, $X_{LoopL23correct}$ or $X_{LoopL31correct}$
$X_{1line}$ = Positive sequence reactance of the electric line (ohm/km)

In case of a non-homogeneous line, i.e. a line comprising several different types of line sections, the conversion of the fault loop reactance into a physical fault distance should be performed considering the non-homogeneity of the line e.g. section by section. The particular way how this may be accomplished, however, is not relevant to the basic idea of the invention.

The phase-to-phase fault distance determination, according to one possible embodiment, may be summarized as follows:

1. In case of a three-phase fault at distance d on the electric line:

    a. Calculate $X_{LoopL12}$, $X_{LoopL23}$, $X_{LoopL31}$, $X_{LoopL123}$ and fault distance d.
    b. Calculate correction factors $X_{LoopL12corr}(d)$, $X_{LoopL23corr}(d)$ and $X_{LoopL31corr}(d)$, and save calculated correction factors with the corresponding fault distance d.

2. In case of a phase-to-phase fault at distance d on the electric line:

a. Select the corresponding correction factor $X_{LoopL12corr}(d)$, $X_{LoopL23corr}(d)$ or $X_{LoopL31corr}(d)$ based on fault distance d.
b. Apply the correction factor to obtain a corrected fault distance estimate for the phase-to-phase fault.

3. Repeat step 1 every time a three-phase fault occurs and collect correction factors as a function of fault distance d.

4. Repeat step 2 every time a phase-to-phase fault occurs.

In the above exemplary embodiment, an initial correction factor value 1 (no correction) may be used in case no correction factors have been determined when a phase-to-phase fault occurs.

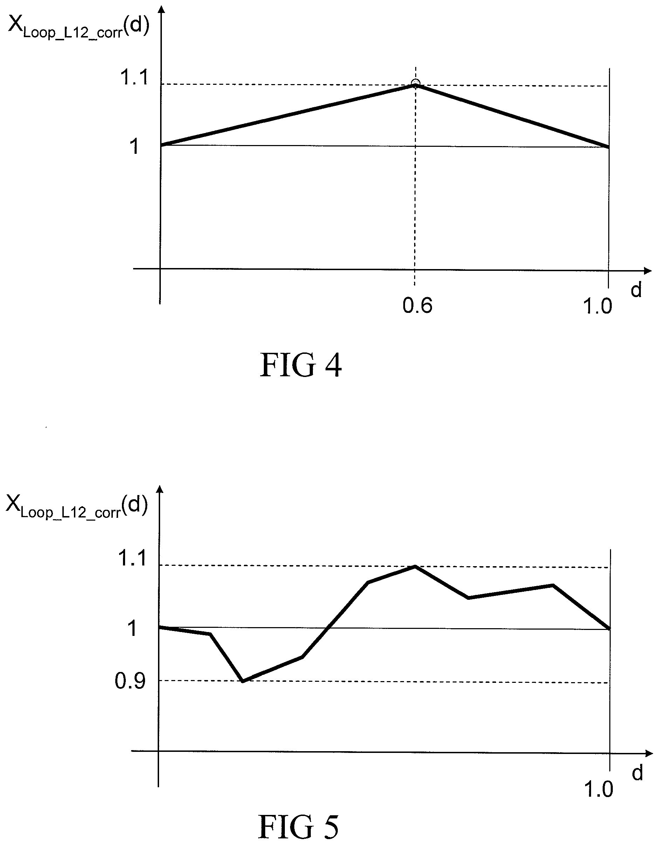

The interpolation of phase-to-phase fault loop reactance unbalance correction factors is illustrated in Figure 4. In the illustrated example a three-phase fault occurs at distance d = 0.6 p.u. from the measuring point. For fault loop L12 a correction factor $X_{LoopL12corr}$ = 1.1 is calculated. This applies to fault distance d = 0.6 p.u. For other fault distances d, the correction factor may be interpolated preferably by using an initial correction factor of 1.0. The interpolated phase-to-phase fault loop reactance unbalance correction factors for fault distances for which no corresponding determined set of phase-to-phase fault loop reactance unbalance correction factors exists are preferably determined in advance, i.e. as soon as a three-phase fault occurs that can be used for determining a set of correction factors and, consequently, interpolation of correction factors for other distances is possible. Although Figure 4 shows only the correction factor diagram for one fault loop, i.e. L12, such diagrams, or corresponding information in another form, are preferably determined in respect of each of the three different phase-to-phase fault loops on the basis of the one or more sets of phase-to-phase fault loop reactance unbalance correction factors determined on the basis of one or more three-phase faults. Preferably interpolated phase-to-phase fault loop reactance unbalance correction factors are determined for all such possible fault distances along the electric line for which no corresponding determined set of phase-to-phase fault loop reactance unbalance correction factors exists.

In time, as several three-phase faults are recorded at different fault distances $d_1$, $d_2$, ..., $d_n$, the correction factors are "mapped" for several line sections of the line. For other fault distances the correction factor values are preferably interpolated. Thus, the correction factors and the corresponding diagram may be updated each time when a new three-phase fault occurs on the electric line and when a corresponding new set of phase-to-phase fault loop reactance unbalance correction factors is determined. For a feeder with highly non-homogeneous tower geometry, the resulting correction factor diagram could be like the one illustrated in Figure 5.

An apparatus according to any one of the above embodiments, or a combination thereof, may be implemented as one unit or as two or more separate units that are configured to implement the functionality of the various embodiments. Here the term 'unit' refers generally to a physical or logical entity, such as a physical device or a part thereof or a software routine. One or more of these units may reside in the protective relay unit 40, for example.

An apparatus according to any one of the embodiments may be implemented by means of a computer or corresponding digital signal processing equipment provided with suitable software, for example. Such a computer or digital signal processing equipment preferably comprises at least a working memory (RAM) providing storage area for arithmetical operations and a central processing unit (CPU), such as a general-purpose digital signal processor. The CPU may comprise a set of registers, an arithmetic logic unit, and a control unit. The control unit is controlled by a sequence of program instructions transferred to the CPU from the RAM. The control unit may contain a number of microinstructions for basic operations. The implementation of microinstructions may vary depending on the CPU design. The program instructions may be coded by a programming language, which may be a high-level programming language, such as C, Java, etc., or a low-level programming language, such as a machine language, or an assembler. The computer may also have an operating system which may provide system services to a computer program written with the program instructions. The computer or other apparatus implementing the invention further preferably comprises suitable input means for receiving e.g. measurement and/or control data, which input means thus enable e.g. the monitoring of current and voltage quantities, and output means for outputting e.g. calculation results and/or control data. It is also possible to use a specific integrated circuit or circuits, or corresponding components and devices for implementing the functionality according to any one of the embodiments.

The invention can be implemented in existing system elements, such as various protective relays or relay arrangements, or by using separate dedicated elements or devices in a centralized or distributed manner. Present protective devices for electric systems, such as protective relays, typically comprise processors and memory that can be utilized in the functions according to embodiments of the invention. Thus, all modifications and configurations required for implementing an embodiment of the invention e.g. in existing protective devices may be performed as software routines, which may be implemented as added or updated software routines. If the functionality of the invention is implemented by software, such software can be provided as a computer program product comprising computer program code which, when run on a computer, causes the computer or corresponding arrangement to perform the functionality according to the invention as described above. Such a computer program code may be stored on a computer readable medium, such as suitable memory means, e.g. a flash memory or a disc memory from which it is loadable to the unit or units executing the program code. In addition, such a computer program code implementing the invention may be loaded to the unit or units executing the computer program code via a suitable data network, for example, and it may replace or update a possibly existing program code.

**Claims**

1. A method for determining a location of a phase-to-phase fault on a three-phase electric line of an electric network, the method comprising:

   monitoring current and voltage quantities of the three-phase electric line (30) at a measuring point;
   determining, after a phase-to-phase fault occurs on the three-phase electric line (30), a phase-to-phase fault loop reactance and an initial estimate of a distance between the measuring point (40) and the point of fault (F) on the basis of current and voltage quantities monitored during the phase-to-phase fault, **characterized in that** the method comprises:

   determining one or more sets of phase-to-phase fault loop reactance unbalance correction factors on the basis of values of current and voltage quantities monitored during one or more three-phase faults, respectively, each set of correction factors corresponding to a distance between the measuring point (40) and a point of fault (F) at which the respective three-phase fault occurs on the three-phase electric line (30), wherein the reactance unbalance correction factor for a phase-to-phase fault loop is a ratio of a three-phase fault loop reactance to the phase-to-phase fault loop reactance of the phase-to-phase fault loop in question;
   determining a phase-to-phase fault loop reactance unbalance correction factor to be used on the basis of the determined one or more sets of phase-to-phase fault loop reactance unbalance correction factors and the initial estimate of the distance between the measuring point (40) and the point of fault (F);
   correcting the determined phase-to-phase fault loop reactance with the determined phase-to-phase fault loop reactance unbalance correction factor to be used by multiplying the determined phase-to-phase fault loop reactance with the determined phase-to-phase fault loop reactance unbalance correction factor to be used; and
   determining a corrected estimate of the distance between the measuring point and the point of fault (F) on the basis of the corrected phase-to-phase fault loop reactance.

2. A method according to claim 1, **characterized by** determining a set of phase-to-phase fault loop reactance unbalance correction factors on the basis of the values of current and voltage quantities monitored during a three-phase fault each time when a three-phase fault occurs on the electric line (30).

3. A method according to claim 1 or 2, **characterized in that** the set of phase-to-phase fault loop reactance unbalance correction factors comprises a reactance unbalance correction factor for each of the three different phase-to-phase fault loops.

4. A method according to any one of claims 1 to 3, **characterized in that** the determining of the phase-to-phase fault loop reactance unbalance correction factor to be used comprises:

   selecting, from among the determined one or more sets of phase-to-phase fault loop reactance unbalance correction factors, a set corresponding to a distance equal to the initial estimate of the distance between the measuring point (40) and the point of fault (F); and
   selecting from the selected set a phase-to-phase fault loop reactance unbalance correction factor corresponding to the faulted phases of the phase-to-phase fault in question.

5. A method according to claim 4, **characterized in that** the determining of the phase-to-phase fault loop reactance unbalance correction factor to be used comprises, when no determined set corresponds to the distance equal to the initial estimate:

selecting, from among the determined one or more sets of phase-to-phase fault loop reactance unbalance correction factors, a set corresponding to a distance closest to the initial estimate of the distance between the measuring point (40) and the point of fault (F); and
selecting from the selected set a phase-to-phase fault loop reactance unbalance correction factor corresponding to the faulted phases of the phase-to-phase fault in question.

6. A method according to claim 4, **characterized in that** the determining of the phase-to-phase fault loop reactance unbalance correction factor to be used comprises, when no determined set corresponds to the distance equal to the initial estimate:

determining a phase-to-phase fault loop reactance unbalance correction factor corresponding to the distance equal to the initial estimate by means of interpolation on the basis of the determined one or more sets of phase-to-phase fault loop reactance unbalance correction factors.

7. A method according to claim 6, **characterized by** determining in advance, on the basis of the determined one or more sets of phase-to-phase fault loop reactance unbalance correction factors, interpolated phase-to-phase fault loop reactance unbalance correction factors, in respect of each of the three different phase-to-phase fault loops, corresponding to fault distances for which no corresponding determined set of phase-to-phase fault loop reactance unbalance correction factors exists.

8. A method according to claim 7, **characterized by** updating the interpolated phase-to-phase fault loop reactance unbalance correction factors each time when a three-phase fault occurs on the electric line (30) and when a corresponding new set of phase-to-phase fault loop reactance unbalance correction factors is determined.

9. A method according to claim 7 or 8, **characterized by** determining interpolated phase-to-phase fault loop reactance unbalance correction factors corresponding to all such possible fault distances along the electric line (30) for which no corresponding determined set of phase-to-phase fault loop reactance unbalance correction factors exists.

10. A computer program product comprising computer program code, wherein the execution of the program code in a computer causes the computer to carry out the steps of the method according to any one of claims 1 to 9.

11. An apparatus for use in locating a phase-to-phase fault on a three-phase electric line of an electric network, the apparatus (40) comprising:

means for monitoring current and voltage quantities of the three-phase electric line (30) at a measuring point (40);
means for determining, after a phase-to-phase fault occurs on the three-phase electric line (30), a phase-to-phase fault loop reactance and an initial estimate of a distance between the measuring point (40) and the point of fault (F) on the basis of current and voltage quantities monitored during the phase-to-phase fault, **characterized in that** the apparatus comprises:

means for determining one or more sets of phase-to-phase fault loop reactance unbalance correction factors on the basis of values of current and voltage quantities monitored during one or more three-phase faults, respectively, each set of unbalance correction factors corresponding to a distance between the measuring point (40) and a point of fault (F) at which the respective three-phase fault occurs on the three-phase electric line (30), wherein the reactance unbalance correction factor for a phase-to-phase fault loop is a ratio of a three-phase fault loop reactance to the phase-to-phase fault loop reactance of the phase-to-phase fault loop in question;
means for determining a phase-to-phase fault loop reactance unbalance correction factor to be used on the basis of the determined one or more sets of phase-to-phase fault loop reactance unbalance correction factors and the initial estimate of the distance between the measuring point (40) and the point of fault (F);
means for correcting the determined phase-to-phase fault loop reactance with the determined phase-to-phase fault loop reactance unbalance correction factor to be used by multiplying the determined phase-to-phase fault loop reactance with the determined phase-to-phase fault loop reactance unbalance correction factor to be used; and
means for determining a corrected estimate of the distance between the measuring point (40) and the point of fault (F) on the basis of the corrected phase-to-phase fault loop reactance.

12. An apparatus according to claim 11, **characterized in that** the means for determining one or more sets of phase-to-phase fault loop reactance unbalance correction factors is adapted to determine a set of phase-to-phase fault loop reactance unbalance correction factors each time when a three-phase fault occurs on the electric line (30).

13. An apparatus according to claim 11 or 12, **characterized in that** the set of phase-to-phase fault loop reactance unbalance correction factors comprises a reactance unbalance correction factor for each of the three different phase-to-phase fault loops.

14. An apparatus according to any one of claims 11 to 13, **characterized in that** the means for determining a phase-to-phase fault loop reactance unbalance correction factor to be used is adapted to select, from among the determined one or more sets of phase-to-phase fault loop reactance unbalance correction factors, a set corresponding to a distance equal to the initial estimate of the distance between the measuring point (40) and the point of fault (F); and to select from the selected set a phase-to-phase fault loop reactance unbalance correction factor corresponding to the faulted phases of the phase-to-phase fault in question.

15. An apparatus according to claim 14, **characterized in that** the means for determining a phase-to-phase fault loop reactance unbalance correction factor to be used is adapted, when no determined set corresponds to the distance equal to the initial estimate, to select, from among the determined one or more sets of phase-to-phase fault loop reactance unbalance correction factors, a set corresponding to a distance closest to the initial estimate of the distance between the measuring point (40) and the point of fault (F); and to select from the selected set a phase-to-phase fault loop reactance unbalance correction factor corresponding to the faulted phases of the phase-to-phase fault in question.

16. An apparatus according to claim 14, **characterized in that** the means for determining a phase-to-phase fault loop reactance unbalance correction factor to be used is adapted, when no determined set corresponds to the distance equal to the initial estimate, to determine a phase-to-phase fault loop reactance unbalance correction factor corresponding to the distance equal to the initial estimate by means of interpolation on the basis of the determined one or more sets of phase-to-phase fault loop reactance unbalance correction factors.

17. An apparatus according to claim 16, **characterized in that** the apparatus comprises means for determining in advance, on the basis of the determined one or more sets of phase-to-phase fault loop reactance unbalance correction factors, interpolated phase-to-phase fault loop reactance unbalance correction factors, in respect of each of the three different phase-to-phase fault loops, corresponding to fault distances for which no corresponding determined set of phase-to-phase fault loop reactance unbalance correction factors exists.

18. An apparatus according to claim 17, **characterized in that** the apparatus comprises means for updating the interpolated phase-to-phase fault loop reactance unbalance correction factors each time when a three-phase fault occurs on the electric line (30) and when a corresponding new set of phase-to-phase fault loop reactance unbalance correction factors is determined.

19. An apparatus according to claim 17 or 18, **characterized in that** the means for determining in advance the interpolated phase-to-phase fault loop reactance unbalance correction factors is adapted to determine the interpolated phase-to-phase fault loop reactance unbalance correction factors corresponding to all such possible fault distances along the electric line (30) for which no corresponding determined set of phase-to-phase fault loop reactance unbalance correction factors exists.

20. An apparatus as claimed in any one of claims 11 to 19, **characterized in that** the apparatus comprises a protective relay.

**Patentansprüche**

1. Verfahren zur Ermittlung einer Position eines Phase-zu-Phase-Fehlers in einer Dreiphasen-Elektroleitung eines elektrischen Netzwerks, wobei das Verfahren umfasst:

Überwachen von Strom- und Spannungsgrößen der Dreiphasen-Elektroleitung (30) an einem Messpunkt;
Ermitteln, nach dem Auftreten eines Phase-zu-Phase-Fehlers auf der Dreiphasen-Elektroleitung (30), einer Phase-zu-Phase-Fehlerschleifenreaktanz und einer anfänglichen Abschätzung eines Abstands zwischen dem Messpunkt (40) und dem Punkt des Fehlers (F) auf der Grundlage von Strom- und Spannungsgrößen, die während des Phase-zu-Phase-Fehlers überwacht werden,
**dadurch gekennzeichnet, dass** das Verfahren umfasst:

Ermitteln einer oder mehrerer Gruppen aus Phase-zu-Phase-Fehlerschleifenreaktanzasymmetriekorrekturfaktoren auf der Grundlage von Werten von Strom- und Spannungsgrößen, die während eines oder mehrerer Dreiphasenfehlern entsprechend überwacht werden, wobei jede Gruppe aus Korrekturfaktoren einem Abstand zwischen dem Messpunkt (40) und einem des Punkt des Fehlers (F) entspricht, an welchem der entsprechende Dreiphasenfehler auf der Dreiphasen-Elektroleitung (30) auftritt, wobei der Reaktanzasymmetriekorrekturfaktor für eine Phase-zu-Phase-Fehlerschleife ein Verhältnis einer Dreiphasen-Fehlerschleifenreaktanz zu der Phase-zu-Phase-Fehlerschleifenreaktanz der fraglichen Phase-zu-Phase-Fehlerschleife ist;
Ermitteln eines anzuwendenden Phase-zu-Phase-Fehlerschleifenreaktanzasymmetriekorrekturfaktors auf der Grundlage der ermittelten einen oder mehreren Gruppen aus Phase-zu-Phase-Fehlerschleifenreaktanzasymmetriekorrekturfaktoren und der anfänglichen Abschätzung des Abstands zwischen dem Messpunkt (40) und dem Punkt des Fehlers (F);
Korrigieren der ermittelten Phase-zu-Phase-Fehlerschleifenreaktanz mit dem ermittelten anzuwendenden Phase-zu-Phase-Fehlerschleifenreaktanzasymmetriekorrekturfaktor durch Multiplizieren der ermittelten Phase-zu-Phase-Fehlerschleifenreaktanz mit dem ermittelten anzuwendenden Phase-zu-Phase-Fehlerschleifenreaktanzasymmetriekorrekturfaktor; und Ermitteln einer korrekten Abschätzung des Abstands zwischen dem Messpunkt und dem Punkt des Fehlers (F) auf der Grundlage der korrigierten Phase-zu-Phase-Fehlerschleifenreaktanz.

2. Verfahren nach Anspruch 1, **gekennzeichnet durch** Ermitteln einer Gruppe aus Phase-zu-Phase-Fehlerschleifenreaktanzasymmetriekorrekturfaktoren auf der Grundlage der Werte von Strom- und Spannungsgrößen, die während eines Dreiphasenfehlers überwacht werden, jedes Mal, wenn ein Dreiphasenfehler auf der Elektroleitung (30) auftritt.

3. Verfahren nach Anspruch 1 oder 2, **dadurch gekennzeichnet, dass** die Gruppe aus Phase-zu-Phase-Fehlerschleifenreaktanzasymmetriekorrekturfaktoren einen Reaktanzasymmetriekorrekturfaktor für jede der drei unterschiedlichen Phase-zu-Phase-Fehlerschleifen umfasst.

4. Verfahren nach einem der Ansprüche 1 bis 3, **dadurch gekennzeichnet, dass** das Ermitteln des Phase-zu-Phase-Fehlerschleifenreaktanzasymmetriekorrekturfaktors, der anzuwenden ist, umfasst:

Auswählen, aus der ermittelten einer oder den mehreren Gruppen aus Phase-zu-Phase-Fehlerschleifenreaktanzasymmetriekorrekturfaktoren, einer Gruppe, die einem Abstand entspricht, der gleich der anfänglichen Abschätzung des Abstands zwischen dem Messpunkt (40) und dem Punkt des Fehlers (F) ist; und
Auswählen, aus der ausgewählten Gruppe, eines Phase-zu-Phase-Fehlerschleifenreaktanzasymmetriekorrekturfaktors, der den fehlerhaften Phasen des fraglichen Phase-zu-Phase-Fehlers entspricht.

5. Verfahren nach Anspruch 4, **dadurch gekennzeichnet, dass** das Ermitteln des anzuwendenden Phase-zu-Phase-Fehlerschleifenreaktanzasymmetriekorrekturfaktors umfasst, wenn keine ermittelte Gruppe dem Abstand entspricht, der gleich der anfänglichen Abschätzung ist:

Auswählen, aus der ermittelten einen oder mehreren Gruppen aus Phase-zu-Phase-Fehlerschleifenreaktanzasymmetriekorrekturfaktor, einer Gruppe, die einem Abstand entspricht, der der anfänglichen Abschätzung des Abstands zwischen dem Messpunkt (40) und dem Punkt des Fehlers (F) am nächsten liegt; und
Auswählen aus der ausgewählten Gruppe eines Phase-zu-Phase-Fehlerschleifenreaktanzasymmetriekorrekturfaktors, der den fehlerhaften Phasen des in Rede stehenden Phase-zu-Phase-Fehlers entspricht.

6. Verfahren nach Anspruch 4, **dadurch gekennzeichnet, dass** das Ermitteln des anzuwendenden Phase-zu-Phase-Fehlerschleifenreaktanzasymmetriekorrekturfaktors umfasst, wenn keine ermittelte Gruppe dem Abstand, der gleich der anfänglichen Abschätzung ist, entspricht:

Ermitteln eines Phase-zu-Phase-Fehlerschleifenreaktanzasymmetriekorrekturfaktors, der dem Abstand entspricht, der gleich der anfänglichen Abschätzung ist, mittels Interpolation auf der Grundlage der einen oder der mehreren Gruppen aus Phase-zu-Phase-Fehlerschleifenreaktanzasymmetriekorrekturfaktoren.

**7.** Verfahren nach Anspruch 6, **gekennzeichnet durch** Ermitteln, im Voraus, auf der Grundlage der ermittelten einen oder mehreren Gruppen aus Phase-zu-Phase-Fehlerschleifenreaktanzasymmetriekorrekturfaktoren von interpolierten Phase-zu-Phase-Fehlerschleifenreaktanzasymmetriekorrekturfaktoren in Bezug auf jede der drei unterschiedlichen Phase-zu-Phase-Fehlerschleifen entsprechend zu Fehlerabständen, für die keine entsprechende ermittelte Gruppe aus Phase-zu-Phase-Fehlerschleifenreaktanzasymmetriekorrekturfaktoren existiert.

**8.** Verfahren nach Anspruch 7, **gekennzeichnet durch** Aktualisieren der interpolierten Phase-zu-Phase-Fehlerschleifenreaktanzasymmetriekorrekturfaktoren jedes Mal, wenn ein Dreiphasen-Fehler auf der Elektroleitung (30) auftritt und wenn eine entsprechende neue Gruppe aus Phase-zu-Phase-Fehlerschleifenreaktanzasymmetriekorrekturfaktoren ermittelt wird.

**9.** Verfahren nach Anspruch 7 oder 8, **gekennzeichnet durch** Ermitteln von interpolierten Phase-zu-Phase-Fehlerschleifenreaktanzasymmetriekorrekturfaktoren entsprechend zu allen derartigen möglichen Fehlerabständen entlang der Elektroleitung (30), für die keine entsprechende ermittelte Gruppe aus Phase-zu-Phase-Fehlerschleifenreaktanzasymmetriekorrekturfaktoren existiert.

**10.** Computerprogrammprodukt mit Computerprogrammcode, wobei die Ausführung des Programmcodes in einem Computer bewirkt, dass der Computer die Schritte des Verfahrens nach einem der Ansprüche 1 bis 9 ausführt.

**11.** Vorrichtung zur Verwendung zum Auffinden eines Phase-zu-Phase-Fehlers auf einer Dreiphasen-Elektroleitung eines elektrischen Netzwerks, wobei die Vorrichtung (40) aufweist:

eine Einrichtung zur Überwachung von Strom- und Spannungsgrößen der Dreiphasen-Elektroleitung (30) an einem Messpunkt (40);
eine Einrichtung zur Ermittlung, nach Auftreten eines Phase-zu-Phase-Fehlers auf der Dreiphasen-Elektroleitung (30), einer Phase-zu-Phase-Fehlerschleifenreaktanz und einer anfänglichen Abschätzung eines Abstands zwischen dem Messpunkt (40) und dem Punkt des Fehlers (F) auf der Grundlage von Strom- und Spannungsgrößen, die während des Phase-zu-Phase-Fehlers überwacht sind, **dadurch gekennzeichnet, dass** die Vorrichtung umfasst:

eine Einrichtung zur Ermittlung einer oder mehrerer Gruppen aus Phase-zu-Phase-Fehlerschleifenreaktanzasymmetriekorrekturfaktoren auf der Grundlage von Werten von Strom- und Spannungsgrößen, die während eines oder mehrerer Dreiphasen-Fehler überwacht werden, wobei jede Gruppe aus Asymmetriekorrekturfaktoren einem Abstand zwischen dem Messpunkt (40) und einem Punkt des Fehlers (F) entspricht, an welchem der entsprechende Dreiphasen-Fehler auf der Dreiphasen-Elektroleitung (30) auftritt, wobei der Reaktanzasymmetriekorrekturfaktor für eine Phase-zu-Phase-Fehlerschleife ein Verhältnis einer Dreiphasen-Fehlerschleifenreaktanz zu der Phase-zu-Phase-Fehlerschleifenreaktanz der fraglichen Phase-zu-Phase-Fehlerschleife ist;
eine Einrichtung zur Ermittlung eines anzuwendenden Phase-zu-Phase-Fehlerschleifenreaktanzasymmetriekorrekturfaktors auf der Grundlage der ermittelten einen oder mehreren Gruppen aus Phase-zu-Phase-Fehlerschleifenreaktanzasymmetriekorrekturfaktoren und der anfänglichen Abschätzung des Abstands zwischen dem Messpunkt (40) und dem Punkt des Fehlers (F);
eine Einrichtung zum Korrigieren der ermittelten Phase-zu-Phase-Fehlerschleifenreaktanz mittels des anzuwendenden ermittelten Phase-zu-Phase-Fehlerschleifenreaktanzasymmetriekorrekturfaktors durch Multiplizieren der ermittelten Phase-zu-Phase-Fehlerschleifenreaktanz mit dem anzuwendenden ermittelten Phase-zu-Phase-Fehlerschleifenreaktanzasymmetriekorrekturfaktor; und
eine Einrichtung zur Ermittlung einer korrigierten Abschätzung des Abstands zwischen dem Messpunkt (40) und dem Punkt des Fehlers (F) auf der Grundlage der korrigierten Phase-zu-Phase-Fehlerschleifenreaktanz.

**12.** Vorrichtung nach Anspruch 11, **dadurch gekennzeichnet, dass** die Einrichtung zur Ermittlung einer oder mehrerer Gruppen aus Phase-zu-Phase-Fehlerschleifenreaktanzasymmetriekorrekturfaktoren ausgebildet ist, eine Gruppe aus Phase-zu-Phase-Fehlerschleifenreaktanzasymmetriekorrekturfaktoren jedes Mal dann zu ermitteln, wenn ein Dreiphasen-Fehler auf der Elektroleitung (30) auftritt.

**13.** Vorrichtung nach Anspruch 11 oder 12, **dadurch gekennzeichnet, dass** die Gruppe aus Phase-zu-Phase-Fehlerschleifenreaktanzasymmetriekorrekturfaktoren einen Reaktanzasymmetriekorrekturfaktor für jede der drei unterschiedlichen Phase-zu-Phase-Fehlerschleifen umfasst.

**14.** Vorrichtung nach einem der Ansprüche 11 bis 13, **dadurch gekennzeichnet, dass** die Einrichtung zur Ermittlung eines anzuwendenden Phase-zu-Phase-Fehlerschleifenreaktanzasymmetriekorrekturfaktors ausgebildet ist, aus der ermittelten einen oder mehreren Gruppen aus Phase-zu-Phase-Fehlerschleifenreaktanzasymmetriekorrekturfaktoren eine Gruppe auszuwählen, die einem Abstand entspricht, der gleich der anfänglichen Abschätzung des Abstands zwischen dem Messpunkt (40) und dem Punkt des Fehlers (F) entspricht; und ferner ausgebildet ist, aus der ausgewählten Gruppe einen Phase-zu-Phase-Fehlerschleifenreaktanzasymmetriekorrekturfaktor auszuwählen, der den fehlerhaften Phasen des fraglichen Phase-zu-Phase-Fehlers entspricht.

**15.** Vorrichtung nach Anspruch 14, **dadurch gekennzeichnet, dass** die Einrichtung zur Ermittlung eines anzuwendenden Phase-zu-Phase-Fehlerschleifenreaktanzasymmetriekorrekturfaktors ausgebildet ist, wenn keine ermittelte Gruppe dem Abstand, der gleich der anfänglichen Abschätzung ist, entspricht, aus der ermittelten einen oder mehreren Gruppen aus Phase-zu-Phase-Fehlerschleifenreaktanzasymmetriekorrekturfaktoren eine Gruppe auszuwählen, die einem Abstand entspricht, der der anfänglichen Abschätzung des Abstands zwischen dem Messpunkt (40) und dem Punkt des Fehlers (F) am nächsten liegt; und ausgebildet ist, aus der ausgewählte Gruppe einen Phase-zu-Phase-Fehlerschleifenreaktanzasymmetriekorrekturfaktor auszuwählen, der den fehlerhaften Phasen des fraglichen Phase-zu-Phase-Fehlers entspricht.

**16.** Vorrichtung nach Anspruch 14, **dadurch gekennzeichnet, dass** die Einrichtung zur Ermittlung eines anzuwendenden Phase-zu-Phase-Fehlerschleifenreaktanzasymmetriekorrekturfaktors ausgebildet ist, wenn keine ermittelte Gruppe dem Abstand entspricht, der gleich der anfänglichen Abschätzung ist, einen Phase-zu-Phase-Fehlerschleifenreaktanzasymmetriekorrekturfaktor, der dem Abstand entspricht, der gleich der anfänglichen Abschätzung ist, mittels Interpolation auf der Grundlage der ermittelten einen oder mehreren Gruppen aus Phase-zu-Phase-Fehlerschleifenreaktanzasymmetriekorrekturfaktoren zu ermitteln.

**17.** Vorrichtung nach Anspruch 16, **dadurch gekennzeichnet, dass** die Vorrichtung eine Einrichtung umfasst, die ausgebildet ist, im Voraus auf der Grundlage der ermittelten einen oder mehreren Gruppen aus Phase-zu-Phase-Fehlerschleifenreaktanzasymmetriekorrekturfaktoren interpolierte Phase-zu-Phase-Fehlerschleifenreaktanzasymmetriekorrekturfaktoren in Bezug auf jede der drei unterschiedlichen Phase-zu-Phase-Fehlerschleifen entsprechend zu Fehlerabständen zu ermitteln, für die keine entsprechende ermittelte Gruppe aus Phase-zu-Phase-Fehlerschleifenreaktanzasymmetriekorrekturfaktoren existiert.

**18.** Vorrichtung nach Anspruch 17, **dadurch gekennzeichnet, dass** die Vorrichtung eine Einrichtung aufweist zur Aktualisierung der interpolierten Phase-zu-Phase-Fehlerschleifenreaktanzasymmetriekorrekturfaktoren, jedes Mal, wenn ein Dreiphasen-Fehler auf der Elektroleitung (30) auftritt und wenn eine entsprechende neue Gruppe aus Phase-zu-Phase-Fehlerschleifenreaktanzasymmetriekorrekturfaktoren ermittelt wird.

**19.** Vorrichtung nach Anspruch 17 oder 18, **dadurch gekennzeichnet, dass** die Einrichtung, die ausgebildet ist, im Voraus die interpolierten Phase-zu-Phase-Fehlerschleifenreaktanzasymmetriekorrekturfaktoren zu ermitteln, ausgebildet ist, die interpolierten Phase-zu-Phase-Fehlerschleifenreaktanzasymmetriekorrekturfaktoren entsprechend zu allen derartigen möglichen Fehlerabständen entlang der Elektroleitung (30) zu ermitteln, für die keine entsprechende ermittelte Gruppe aus Phase-zu-Phase-Fehlerschleifenreaktanzasymmetriekorrekturfaktoren existiert.

**20.** Vorrichtung nach einem der Ansprüche 11 bis 19, **dadurch gekennzeichnet, dass** die Vorrichtung ein Schutzrelais aufweist.

## Revendications

**1.** Procédé pour déterminer un emplacement d'un défaut entre phases sur une ligne électrique triphasée d'un réseau électrique, le procédé comprenant de :

surveiller des quantités de courant et de tension de la ligne électrique triphasée (30) à un point de mesure ; déterminer, après l'apparition d'un défaut entre phases sur la ligne électrique triphasée (30), une réactance de boucle de défaut entre phases et une estimation initiale d'une distance entre le point de mesure (40) et le point de défaut (F) sur la base de quantités de courant et de tension surveillées pendant le défaut entre phases, **caractérisé en ce que** le procédé comprend de :

déterminer un ou plusieurs ensembles de facteurs de correction de déséquilibre de réactance de boucle de défaut entre phases sur la base de valeurs de quantités de courant et de tension surveillées pendant un ou plusieurs défauts triphasés, respectivement, chaque ensemble de facteurs de correction correspondant à une distance entre le point de mesure (40) et un point de défaut (F) au niveau duquel le défaut triphasé respectif se produit sur la ligne électrique triphasée (30), dans lequel le facteur de correction de déséquilibre de réactance pour une boucle de défaut entre phases est un rapport entre une réactance de boucle de défaut triphasé et la réactance de boucle de défaut entre phases de la boucle de défaut entre phases en question ;

déterminer un facteur de correction de déséquilibre de réactance de boucle de défaut entre phases à utiliser sur la base des un ou plusieurs ensembles déterminés de facteurs de correction de déséquilibre de réactance de boucle de défaut entre phases et de l'estimation initiale de la distance entre le point de mesure (40) et le point de faute (F) ;

corriger la réactance de boucle de défaut entre phases déterminée à l'aide du facteur de correction de déséquilibre de réactance de boucle de défaut entre phases déterminé à utiliser en multipliant la réactance de boucle de défaut entre phases déterminée avec le facteur de correction de déséquilibre de réactance de boucle de défaut entre phases déterminé à utiliser ; et

déterminer une estimation corrigée de la distance entre le point de mesure et le point de défaut (F) sur la base de la réactance corrigée de boucle de défaut entre phases.

2. Procédé selon la revendication 1, **caractérisé par** la détermination d'un ensemble de facteurs de correction de déséquilibre de réactance de boucle de défaut entre phases sur la base des valeurs de quantités de courant et de tension surveillées pendant un défaut triphasé à chaque fois qu'un défaut triphasé se produit sur la ligne électrique (30).

3. Procédé selon la revendication 1 ou 2, **caractérisé en ce que** l'ensemble de facteurs de correction de déséquilibre de réactance en boucle de défaut entre phases comprend un facteur de correction de déséquilibre de réactance pour chacune des trois boucles de défaut entre phases différentes.

4. Procédé selon l'une quelconque des revendications 1 à 3, **caractérisé en ce que** la détermination du facteur de correction de déséquilibre de réactance de boucle de défaut entre phases à utiliser comprend de :

sélectionner, parmi les un ou plusieurs ensembles déterminés de facteurs de correction de déséquilibre de réactance de boucle de défaut entre phases, un ensemble correspondant à une distance égale à l'estimation initiale de la distance entre le point de mesure (40) et le point de défaut (F) ; et

sélectionner dans l'ensemble sélectionné un facteur de correction de déséquilibre de réactance de boucle de défaut entre phases correspondant aux phases défaillantes du défaut entre phases en question.

5. Procédé selon la revendication 4, **caractérisé en ce que** la détermination du facteur de correction de déséquilibre de réactance de boucle de défaut entre phases comprend de, lorsque aucun ensemble déterminé ne correspond à la distance égale à l'estimation initiale :

sélectionner, parmi les un ou plusieurs ensembles déterminés de facteurs de correction de déséquilibre de réactance de boucle de défaut entre phases, un ensemble correspondant à une distance la plus proche de l'estimation initiale de la distance entre le point de mesure (40) et le point de défaut (F) ; et

sélectionner dans l'ensemble sélectionné un facteur de correction de déséquilibre de réactance de boucle de défaut entre phases correspondant aux phases défaillantes du défaut entre phases en question.

6. Procédé selon la revendication 4, **caractérisé en ce que** la détermination du facteur de correction de déséquilibre de réactance de boucle de défaut entre phases à utiliser comprend de, lorsqu'aucun ensemble déterminé ne correspond à la distance égale à l'estimation initiale :

déterminer un facteur de correction de déséquilibre de réactance de boucle de défaut entre phases correspondant à la distance égale à l'estimation initiale au moyen d'une interpolation sur la base des un ou plusieurs ensembles déterminés de facteurs de correction de déséquilibre de réactance de boucle de défaut entre phases.

7. Procédé selon la revendication 6, **caractérisé par** la détermination à l'avance, sur la base des un ou plusieurs ensembles déterminés de facteurs de correction de déséquilibre de réactance de boucle de défaut entre phases, de facteurs de correction interpolés de déséquilibre de réactance de boucle de défaut entre phases, pour chacune des trois boucles de défaut entre phases différentes, correspondant à des distances de défaut pour lesquelles il n'existe aucun ensemble déterminé correspondant de facteurs de correction de déséquilibre de réactance de boucle de défaut entre phases.

8. Procédé selon la revendication 7, **caractérisé par** la mise à jour des facteurs de correction interpolés de déséquilibre de réactance de boucle de défaut entre phases à chaque fois qu'un défaut triphasé se produit sur la ligne électrique (30) et qu'un nouvel ensemble correspondant de facteurs de correction de déséquilibre de réactance de boucle de défaut entre phases est déterminé.

9. Procédé selon la revendication 7 ou 8, **caractérisé par** la détermination de facteurs de correction interpolés de déséquilibre de réactance de boucle de défaut entre phases correspondant à toutes les distances de défaut possibles le long de la ligne électrique (30) pour lesquelles il n'existe aucun ensemble déterminé correspondant de facteurs de correction de déséquilibre de réactance de boucle de défaut entre phases.

10. Produit de programme informatique comprenant un code de programme informatique, dans lequel l'exécution du code de programme dans un ordinateur amène l'ordinateur à effectuer les étapes du procédé selon l'une quelconque des revendications 1 à 9.

11. Appareil à utiliser pour localiser un défaut entre phases sur une ligne électrique triphasée d'un réseau électrique, l'appareil (40) comprenant :

des moyens pour surveiller des quantités de courant et de tension de la ligne électrique triphasée (30) à un point de mesure (40) ;
des moyens pour déterminer, après l'apparition d'un défaut entre phases sur la ligne électrique triphasée (30), une réactance de boucle de défaut entre phases et une estimation initiale d'une distance entre le point de mesure (40) et le point de défaut (F) sur la base de quantités de courant et de tension surveillées pendant le défaut entre phases, **caractérisé en ce que** l'appareil comprend :

des moyens pour déterminer un ou plusieurs ensembles de facteurs de correction de déséquilibre de réactance de boucle de défaut entre phases sur la base de valeurs de quantités de courant et de tension surveillées pendant un ou plusieurs défauts triphasés, respectivement, chaque ensemble de facteurs de correction de déséquilibre correspondant à distance entre le point de mesure (40) et un point de défaut (F) au niveau duquel le défaut triphasé respectif se produit sur la ligne électrique triphasée (30), dans lequel le facteur de correction de déséquilibre de réactance pour une boucle de défaut entre phases est le rapport entre une réactance de boucle de défaut triphasé et la réactance de boucle de défaut entre phases de la boucle de défaut entre phases en question ;
des moyens pour déterminer un facteur de correction de déséquilibre de réactance de boucle de défaut entre phases à utiliser sur la base des un ou plusieurs ensembles déterminés de facteurs de correction de déséquilibre de réactance de boucle de défaut entre phases et de l'estimation initiale de la distance entre le point de mesure (40) et le point de défaut (F) ;
des moyens pour corriger la réactance de boucle de défaut entre phases déterminée à l'aide du facteur de correction de déséquilibre de réactance de boucle de défaut entre phases déterminé à utiliser en multipliant la réactance de boucle de défaut entre phases déterminée avec facteur de correction déterminé de déséquilibre de réactance de boucle de défaut entre phases à utiliser ; et
des moyens pour déterminer une estimation corrigée de la distance entre le point de mesure (40) et le point de défaut (F) sur la base de la réactance corrigée de boucle de défaut entre phases.

12. Appareil selon la revendication 11, **caractérisé en ce que** les moyens pour déterminer un ou plusieurs ensembles de facteurs de correction de déséquilibre de réactance de boucle de défaut entre phases sont adaptés pour déterminer un ensemble de facteurs de correction de déséquilibre de réactance de boucle entre phases à chaque fois qu'un défaut triphasé se produit sur la ligne électrique (30).

13. Appareil selon la revendication 11 ou 12, **caractérisé en ce que** l'ensemble de facteurs de correction de déséquilibre de réactance de boucle de défaut entre phases comprend un facteur de correction de déséquilibre de réactance pour chacune des trois boucles de défaut entre phases différentes.

14. Appareil selon l'une quelconque des revendications 11 à 13, **caractérisé en ce que** les moyens pour déterminer un facteur de correction de déséquilibre de réactance de boucle de défaut entre phases à utiliser sont adaptés pour sélectionner, parmi les un ou plusieurs ensembles déterminés de facteurs de correction de déséquilibre de réactance de boucle de défaut entre phases, un ensemble correspondant à une distance égale à l'estimation initiale de la distance entre le point de mesure (40) et le point de défaut (F) ; et pour sélectionner parmi l'ensemble sélectionné un facteur de correction de déséquilibre de réactance de boucle de défaut entre phases correspondant aux phases défaillantes du défaut entre phases en question.

15. Appareil selon la revendication 14, **caractérisé en ce que** les moyens pour déterminer un facteur de correction de déséquilibre de réactance de boucle de défaut entre phases à utiliser sont adaptés, lorsque aucun ensemble déterminé ne correspond à la distance égale à l'estimation initiale, pour sélectionner, parmi les un ou plusieurs ensembles déterminés de facteurs de correction de déséquilibre de réactance de boucle de défaut entre phases, un ensemble correspondant à une distance la plus proche de l'estimation initiale de la distance entre le point de mesure (40) et le point de défaut (F) ; et pour sélectionner parmi l'ensemble sélectionné un facteur de correction de déséquilibre de réactance de boucle de défaut entre phases correspondant aux phases défaillantes du défaut entre phases en question.

16. Appareil selon la revendication 14, **caractérisé en ce que** les moyens pour déterminer un facteur de correction de déséquilibre de réactance de boucle de défaut entre phases à utiliser sont adaptés, lorsque aucun ensemble déterminé ne correspond à la distance égale à l'estimation initiale, pour déterminer un facteur de correction de déséquilibre de réactance de boucle de défaut entre phases correspondant à la distance égale à l'estimation initiale au moyen d'une interpolation sur la base des un ou plusieurs ensembles déterminés de facteurs de correction de déséquilibre de réactance de boucle de défaut entre phases.

17. Appareil selon la revendication 16, **caractérisé en ce que** l'appareil comprend des moyens pour déterminer à l'avance, sur la base des un ou plusieurs ensembles déterminés de facteurs de correction de déséquilibre de réactance de boucle de défaut entre phases, des facteurs de correction interpolés de déséquilibre de réactance de boucle de défaut entre phases, pour chacune des trois boucles de défaut entre phases différentes, correspondant à des distances de défaut pour lesquelles il n'existe aucun ensemble déterminé correspondant de facteurs de correction de déséquilibre de réactance de boucle de défaut entre phases.

18. Appareil selon la revendication 17, **caractérisé en ce que** l'appareil comprend des moyens pour mettre à jour les facteurs de correction interpolés de déséquilibre de réactance de boucle de défaut entre phases à chaque fois qu'un défaut triphasé se produit sur la ligne électrique (30) et qu'un nouvel ensemble correspondant de facteurs de correction de déséquilibre de réactance de boucle de défaut entre phases est déterminé.

19. Appareil selon la revendication 17 ou 18, **caractérisé en ce que** les moyens pour déterminer à l'avance les facteurs de correction interpolés de déséquilibre de réactance de boucle de défaut entre phases sont adaptés pour déterminer les facteurs de correction interpolés de déséquilibre de réactance de boucle de défaut entre phases correspondant à toutes les distances de défaut possibles le long de la ligne électrique (30) pour lesquelles il n'existe aucun ensemble déterminé correspondant de facteurs de correction de déséquilibre de réactance de boucle de défaut entre phases.

20. Appareil selon l'une quelconque des revendications 11 à 19, **caractérisé en ce que** l'appareil comprend un relais de protection.

**FIG 1**

**FIG 2**

**FIG 3**

FIG 4

FIG 5

# REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 1172660 A

**Non-patent literature cited in the description**

- **IGEL, M. ; SCHENGER, P. ; SIMON, R.** Distance protection of asymmetrical overhead lines. *CIRED. 14th International Conference and Exhibition on Electricity Distribution. Part 1: Contributions. (IEE Conf. Publ. No. 438),* 02 June 1997, vol. 4, 21, , 1-21, 7

- **PEREIRA, C. ED. M. ; ZANETTA, L.C., JR.** Optimization algorithm for fault location in transmission lines considering current transformers saturation. *IEEE Transactions on Power Delivery,* April 2005, vol. 20 (2), 603-608
- **KAWADY, T. ; STENZEL, J.** A practical fault location approach for double circuit transmission lines using single end data. *IEEE Transactions on Power Delivery,* October 2003, vol. 18 (4), 1166-1173